# EUROPÄISCHE PATENTSCHRIFT

(11) **EP 1 451 597 B1**
(45) Veröffentlichungstag und Bekanntmachung des Hinweises auf die Patenterteilung: **03.06.2009**
(21) Anmeldenummer: 02779838.8
(22) Anmeldetag: 07.11.2002
(51) Int. Cl.: G01R 31/06, G01R 31/42, G01R 31/02, G01R 31/34

(54) **VERFAHREN ZUM DETEKTIEREN EINES IN EINER ELEKTRISCHEN EINRICHTUNG IN DER NÄHE EINES NEUTRALEN PUNKTES AUFTRETENDEN ERDSCHLUSSES SOWIE VORRICHTUNG ZUR DURCHFÜHRUNG DES VERFAHRENS**
METHOD AND APPARATUS FOR GROUND FAULT DETECTION CLOSE TO A NEUTRAL POINT
DETECTEUR DE MISE A LA TERRE POUR BOBINAGES

(30) Priorität: 19.11.2001 CH 211301
(43) Veröffentlichungstag der Anmeldung: 01.09.2004
(73) Patentinhaber: Alstom Technology Ltd, 5400 Baden (CH)
(72) Erfinder: LINDAHL, Göran, S-721 76 Västeras (SE); SÖRENSEN, Erland, S-723 55 Västeras (SE)
(86) Internationale Anmeldenummer: PCT/IB2002/004687
(87) Internationale Veröffentlichungsnummer: WO 2003/044546

(56) Entgegenhaltungen:
- EP-A- 1 004 884
- US-A- 4 228 475
- US-A- 4 901 070
- US-A- 6 064 172
- PATENT ABSTRACTS OF JAPAN vol. 1999, no. 01, 29 January 1999 (1999-01-29) & JP 10 271651 A (TOSHIBA CORP), 9 October 1998 (1998-10-09)
- PATENT ABSTRACTS OF JAPAN vol. 010, no. 266 (P-496), 11 September 1986 (1986-09-11) & JP 61 091576 A (SUMITOMO ELECTRIC IND LTD), 9 May 1986 (1986-05-09)
- PATENT ABSTRACTS OF JAPAN vol. 012, no. 276 (P-737), 30 July 1988 (1988-07-30) & JP 63 055472 A (SUMITOMO ELECTRIC IND LTD), 9 March 1988 (1988-03-09)
- PATENT ABSTRACTS OF JAPAN vol. 015, no. 284 (E-1091), 18 July 1991 (1991-07-18) & JP 03 098214 A (FUJIKURA LTD), 23 April 1991 (1991-04-23)

## Beschreibung

### TECHNISCHES GEBIET

Die vorliegende Erfindung bezieht sich auf das Gebiet der Schutztechnik von elektrischen Einrichtungen wie elektrischen Maschinen oder Transformatoren. Sie betrifft ein Verfahren zum Detektieren eines in der Nähe eines neutralen Punktes auftretenden Erdschlusses in einer mehrphasigen, mit einer Grundfrequenz betriebenen, elektrischen Einrichtung gemäss dem Oberbegriff des Anspruchs 1. Sie betrifft weiterhin eine Vorrichtung zur Durchführung des Verfahrens sowie eine Anwendung des Verfahrens.

### STAND DER TECHNIK

Aus dem Stand der Technik ist eine Vielzahl von Verfahren bekannt, mit denen Erdschlüsse oder Erdfehler in den Wicklungen von rotierenden Maschinen, wie Synchrongeneratoren, detektiert und damit die Maschine vor den negativen Auswirkungen von Erdschlüssen geschützt werden kann. Dazu gehört die Verwendung eines Ueberspannungs- oder Ueberstromrelais am neutralen Punkt, eines Nullspannungs (zero sequence)-Ueberspannungsrelais oder einer Reststromdifferentialschutzschaltung. Ausserdem ist es auf diesem Gebiet an sich bekannt, mit einem Erdschluss einhergehende Änderungen physikalischer Grössen, insbesondere der Temperatur, zu messen und auszuwerten, wie in US 4901070 offenbart.

Der Erdfehlerschutz eines Generators auf der Basis einer Ueberspannungs- oder Ueberstrombestimmung ergibt einen einfachen und zuverlässigen Schutz. Er hat jedoch einen wesentlichen Nachteil: Erdschlüsse, die in den Wicklungen nahe dem neutralen Punkt des Generators auftreten, werden nicht erfasst. Es ist deshalb bereits vorgeschlagen worden (Charles S: Mozina, Upgrading Hydroelectric Generator Protection Using Digital Technology, Waterpower '97, Atlanta GA, August 5-8 (1997)), einen hundertprozentigen Erdfehlerschutz dadurch zu erreichen, dass man eine herkömmliche Ueberspannungsschutzschaltung (für 95% der Statorwicklung) mit einer auf die dritte Harmonische der Generatorgrundfrequenz abgestimmte Unterspannungsschutzschaltung (für die restlichen 5% der Wicklung nahe dem neutralen Punkt) kombiniert. Dieser Vorschlag basiert auf dem Umstand, dass in vielen Synchrongeneratoren die induzierte elektromotorische Spannung am neutralen Punkt höhere Harmonische enthält, die in der Verbindung des neutralen Punktes zur Erde, in der Regel einem Widerstand, einen entsprechenden höher harmonischen Strom erzeugen. Tritt in der Nähe zum neutralen Punkt ein Erdschluss auf, wirkt er als Bypass zu diesem Widerstand. Die durch den Bypass hervorgerufene Reduktion des Spannungsabfalls kann dann als Unterspannung detektiert werden. Diese bekannten Erdfehlerschutzverfahren werden unterstützt durch den Einsatz von Aufwärtstransformatoren zwischen Generator und Netz, die im Hinblick auf die Erdung eine Trennung des Generators vom Netz ermöglichen.

In jüngster Zeit werden jedoch zunehmend Kraftwerkskonfigurationen eingesetzt, bei denen auf die üblichen Aufwärtstransformatoren verzichtet werden kann, weil die Generatoren die Netzspannung direkt erzeugen. Erreicht wird dies durch eine spezielle Wicklungstechnik, bei der die Wicklungen des Generators mit Hochspannungskabeln ausgeführt werden. Derartige Generatoren sind unter der Bezeichnung "Powerformer" bekannt geworden (siehe z.B. M. Leijon, "Powerformer - a radically new rotating machine", ABB review 2/98, pp. 21-26 (1998)).

Es hat sich nun herausgestellt, dass die bekannten Methoden zur Detektion von Erdfehlern bei diesen in der neuen Wicklungstechnik ausgeführten rotierenden Maschinen und Transformatoren nicht hundertprozentig zuverlässig arbeiten.

### DARSTELLUNG DER ERFINDUNG

Es ist Aufgabe der Erfindung, ein Verfahren und eine Vorrichtung anzugeben, welche die Nachteile bisher bekannter Lösungen vermeiden und insbesondere eine einfache und sichere Detektion von Erdfehlern bzw. Erdschlüssen nahe am neutralen Punkt von mit Kabeln bewickelten bzw. direkt ans Netz angeschlossenen elektrischen Maschinen und Transformatoren ermöglichen.

Die Aufgabe wird durch die Gesamtheit der Merkmale der Ansprüche 1 und 2 gelöst. Der Kern der Erfindung besteht darin, die Auswirkungen eines Erdschlusses auf die unmittelbare Umgebung des Erdschlusses, die sich in einer Aenderung bestimmter physikalischer Grössen wie z.B. Temperatur oder Druck äussern, messtechnisch zu erfassen und zur Detektion des Erdschlusses heranzuziehen.

Das erfindungsgemässe Verfahren zeichnet sich dadurch aus, dass für die Wicklungen ein Hochspannungskabel mit einem eingebauten gasgefüllten Rohr verwendet wird, und dass die Aenderung des Gasdruckes im Rohr gemessen und ausgewertet wird.

Eine entsprechende Vorrichtung ist dadurch gekennzeichnet, dass die Hochspannungskabel jeweils ein gasgefülltes Rohr aufweisen, und dass die Messwertaufnahmemittel Druckaufnehmer umfassen, welche mit den Rohren in Verbindung stehen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in einer schematisierten Darstellung ein Ausführungsbeispiel einer Vorrichtung nach der Erfindung zur Erdfehlerdetektion mittels Druckabtastung in einem Wicklungskabel nach Fig. 2;
- Fig. 2: den Querschnitt durch ein in den Wicklungen eingesetztes Kabel mit einem Zwischenraum, wie es zur Durchführung eines Erdfeh- lerdetektionsverfahrens gemäss der Erfindung geeignet ist; und

### WEGE ZUR AUSFÜHRUNG DER ERFINDUNG

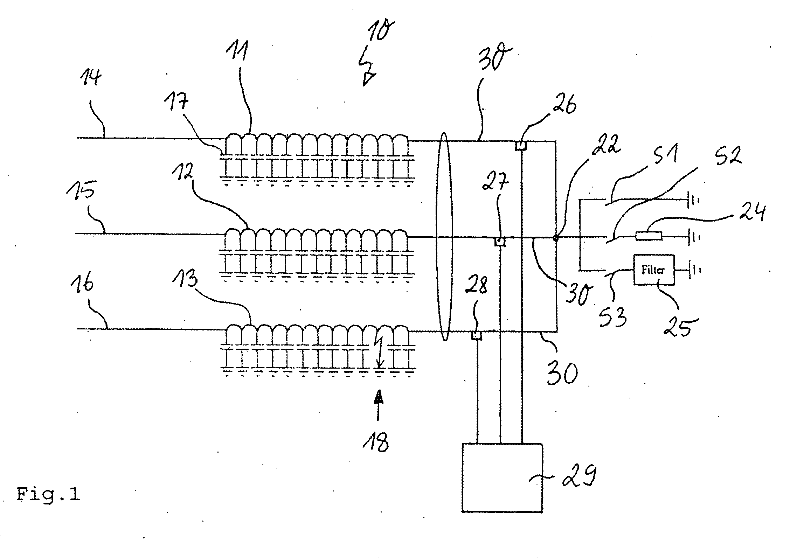

Gemäss der Erfindung wird ein möglicher Erdschluss durch eine Messung bestimmter physikalischer Grössen detektiert, die sich infolge des Erdschlusses ändern. In Fig. 1 st in einer schematisierten Darstellung ein Ausführungsbeispiel einer Vorrichtung nach der Erfindung zur Erdschluss- bzw. Erdfehlerdetektion in den Wicklungen 11, 12 und 13 einer elektrischen Maschine 10 wiedergegeben. Die mit Hochspannungskabeln ausgeführten Wicklungen 11, 12, 13 sind auf der einen Seite über Netzanschlüsse 14, 15 und 16 direkt an ein (nicht dargestelltes) Netz angeschlossen. Auf der anderen Seite sind die Wicklungen 11, 12 und 13 mit einem neutralen Punkt 22 verbunden, der über Schalter S1,..,S3 entweder direkt, über einen Widerstand 24 oder über ein Filter 25 auf Erde geführt sein kann. Die Wicklungen 11, 12 und 13 weisen gegenüber Erde verteilte Erdkapazitäten 17 auf, die in Fig. 1 angedeutet sind.

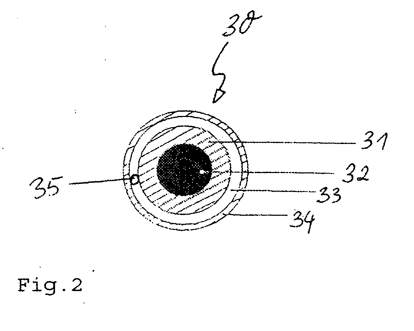

Für den Aufbau der Wicklungen 11, 12 und 13 wird ein spezielles Hochspannungskabel 30 verwendet, dessen innerer Aufbau vereinfacht in der Querschnittsdarstellung der Fig. 2 gezeigt ist. Das Hochspannungkabel 30 ist ein sogenanntes XLPE-Kabel (XLPE steht dabei für "cross-linked polyethylene"; siehe z.B. den Artikel von B. Dellby et al. "High-voltage XLPERFORMANCE cable technology, ABB review 4/2000, S. 35-44 (2000)). Bei dem XLPE-Kabel ist generell der zentrale Leiter 32 von einer Isolation aus XLPE umgeben. Die Besonderheit des Hochspannungskabels 30 aus Fig. 2 besteht nun darin, dass zwischen einer ersten und zweiten Isolation 31 bzw. 34 ein Zwischenraum 33 angeordnet ist. In diesem Zwischenraum 33 kann spiralförmig ein mit Gas gefülltes Rohr 35 verlegt sein. Als Füllgas kommt dabei insbesondere SF₆ in Betracht.

Gemäss Fig. 1 können nun an einer oder mehreren Stellen des Hochspannungskabels 30 bzw. der Wicklungen 11, 12, 13 Druckaufnehmer 26, 27, 28 angeordnet sein. Im Falle eines Erdschlusses 18 tritt Gas aus dem Rohr aus und die damit verbundene Druckänderung kann mittels der Druckaufnehmer 26, 27, 28 gemessen und in einer angeschlossenen Auswerteeinheit 29 ausgewertet werden.

### BEZUGSZEICHENLISTE

- 10: elektrische Maschine
- 11,12,13: Wicklung
- 14,15,16: Netzanschluss
- 17: Erdkapazität
- 18: Erdschluss
- 22: neutraler Punkt
- 24: Widerstand
- 25: Filter
- 26,27,28: Druckaufnehmer
- 29: Auswerteeinheit
- 30: Hochspannungskabel (XLPE)
- 31: Isolation (XLPE)
- 32: Leiter
- 33: Zwischenraum
- 34: Isolation (XLPE)
- 35: Rohr (gasgefüllt, z.B. mit SF₆)
- S1,S2,S3: Schalter

## Patentansprüche

1. Verfahren zum Detektieren eines in der Nähe eines neutralen Punktes (22) auftretenden Erdschlusses (18) in einer mehrphasigen, mit einer Grundfrequenz betriebenen, elektrischen Einrichtung, insbesondere einer elektrischen Maschine (10) oder eines Transformators, welche eine Mehrzahl von den einzelnen Phasen zugeordneten Wicklungen (11, 12, 13) eines Hochspannungskabels (30) aufweist, die jeweils mit dem einen Ende an den neutralen Punkt (22) und mit dem anderen Ende über einen Netzanschluss (14, 15, 16) direkt an ein Stromnetz angeschlossen sind, wobei die mit einem Erdschluss (18) verbundene Aenderung physikalischer Grössen in der unmittelbaren Umgebung des Erdschlusses (18) gemessen und ausgewertet wird, **dadurch gekennzeichnet, dass** für die Wicklungen ein Hochspannungskabel (30) mit einem eingebauten gasgefüllten Rohr (35) verwendet wird, und dass die Aenderung des Gasdruckes im Rohr (35) gemessen und ausgewertet wird.

2. Vorrichtung zur Durchführung des Verfahrens nach Anspruch 1, **dadurch gekennzeichnet, dass** an den einzelnen Wicklungen (11, 12, 13) Mittel (19,..,21; 26,..,28) zur Messwertaufnahme von physikalischen Grössen angeordnet sind, welche sich beim Auftreten eines Erdschlusses in den Wicklungen (11, 12, 13) ändern, und dass die Messwertaufnahmemittel (19,..,21; 26,..,28) mit einer Auswerteeinheit (23, 29) in Verbindung stehen, **dadurch gekennzeichnet, dass** die Hochspannungskabel (30) jeweils ein gasgefülltes Rohr (35) aufweisen, und dass die Messwertaufnahmemittel Druckaufnehmer (26, 27, 28) umfassen, welche mit den Rohren (35) in Verbindung stehen.

## Claims

1. Method for detection of a ground fault (18), which occurs in the vicinity of a neutral point (22) in a polyphase electrical device which is operated at a fundamental frequency, in particular an electrical machine (10) or a transformer which has a number of windings (11, 12, 13), which are associated with the individual phases of a high-voltage cable (30), one end of each of which windings (11, 12, 13) is connected to the neutral point (22) and the other end of each of which windings (11, 12, 13) is connected directly to a power supply network via a power supply system connection (14, 15, 16), with the change in the physical variables which is associated with a ground fault (18) being measured in the immediate vicinity of the ground fault (18), and being evaluated, **characterized in that** a high-voltage cable (30) with a built-in gas-filled tube (35) is used for the windings, and **in that** the change in the gas pressure in the tube (35) is measured and evaluated.

2. Apparatus for carrying out the method to claim 1, **characterized in that** means (19,..., 21; 26,...,28) for measured value recording of physical variables which change when a ground fault occurs in the windings (11, 12, 13) are arranged on the individual windings (11, 12, 13), and **in that** the measured value recording means (19,..., 21; 26,...,28) are connected to an evaluation unit (23, 29), **characterized in that** the high-voltage cables (30) each have a gas-filled tube (35), and **in that** the measured value recording means comprise pressure sensors (26, 27, 28), which are connected to the tubes (35).

## Revendications

1. Procédé pour détecter un court-circuit à la terre (18) qui se produit à proximité d'un point neutre (22) dans un équipement électrique à plusieurs phases fonctionnant à une fréquence de base, notamment une machine électrique (10) ou un transformateur, lequel présente une pluralité d'enroulements (11, 12, 13) d'un câble à haute tension (30) associés à chacune des phases, lesquels sont respectivement raccordés avec une extrémité au point neutre (22) et avec l'autre extrémité directement à un réseau électrique par le biais d'une borne de réseau (14, 15, 16), les modifications de grandeurs physiques qui sont liées à un court-circuit à la terre (18) étant mesurées dans l'environnement immédiat du court-circuit à la terre (18) et interprétées, **caractérisé en ce qu'**un câble à haute tension (30) muni d'un tube (35) rempli de gaz incorporé est utilisé pour les enroulements et que la modification de la pression de gaz dans le tube (35) est mesurée et interprétée.

2. Dispositif pour mettre en oeuvre le procédé selon la revendication 1, **caractérisé en ce que** des moyens (19, ..., 21 ; 26, ..., 28) d'acquisition des valeurs mesurées des grandeurs physiques sont disposés sur les enroulements individuels (11, 12, 13), lesquels subissent une modification lorsqu'il se produit un court-circuit à la terre dans les enroulements (11, 12, 13), et que les moyens d'acquisition des valeurs mesurées (19, ..., 21 ; 26, ..., 28) sont en liaison avec une unité d'interprétation (23, 29), **caractérisé en ce que** les câbles à haute tension (30) présentent respectivement un tube (35) rempli de gaz et que les moyens d'acquisition des valeurs mesurées comprennent des capteurs de pression (26, 27, 28) qui sont en liaison avec les tubes (35).
